# EUROPÄISCHE PATENTSCHRIFT

(11) **EP 0 961 291 B1**
(45) Veröffentlichungstag und Bekanntmachung des Hinweises auf die Patenterteilung: **27.09.2006**
(21) Anmeldenummer: 99110239.3
(22) Anmeldetag: 26.05.1999
(51) Int. Cl.: G11C 17/18, G11C 17/16

(54) **Fuselatch-Schaltung**
Fuse latch circuit
Circuit de verrouillage à fusible

(30) Priorität: 27.05.1998 DE 19823687
(43) Veröffentlichungstag der Anmeldung: 01.12.1999
(73) Patentinhaber: Infineon Technologies AG, 81669 München (DE)
(72) Erfinder: Schneider, Helmut, 80993 München (DE); Le, Thoai-Thai, 81737 München (DE)
(74) Vertreter: Müller - Hoffmann & Partner

(56) Entgegenhaltungen:
- US-A- 5 566 107
- US-A- 5 619 469
- US-A- 5 680 360

## Beschreibung

Die vorliegende Erfindung betrifft eine Fuselatch-Schaltung, bei der mittels eines ersten und eines zweiten Steuersignales, die zeitversetzt zueinander sind, einem Zustand einer Fuse entsprechende Information ( d.h. Fuse ist defekt oder intakt) aus der Fuse in ein Latchglied auslesbar und in diesem speicherbar ist, nach dem Oberbegriff des Patentanspruches 1.

In einer Fuselatch-Schaltung soll Fuse-Information für den Betreib eines Halbleiterbauelements, beispielsweise eines Halbleiterspeichers, speicherbar sein, nachdem beim Einschalten der Versorgungsspannung die Fuse-Information aus der Fuse ausgelesen wurde.

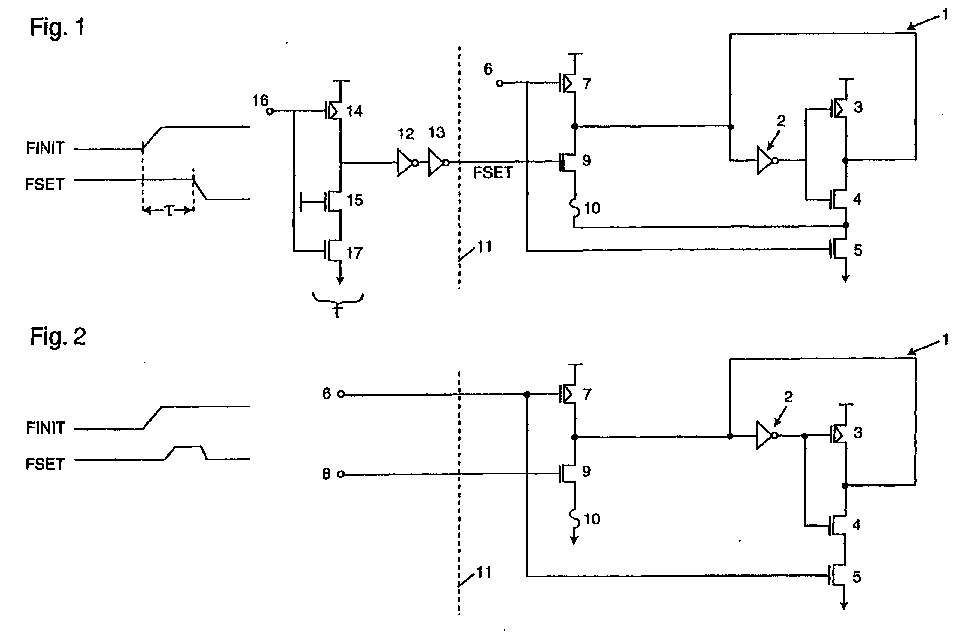

Fig. 2 zeigt eine solche bestehende Fuselatch-Schaltung aus einem Latch-Speicherglied 1 mit einem ersten Inverter 2, einem zweiten Inverter aus einem p-Kanal-MOS-Transistor 3 und einem n-Kanal-MOS-Transistor 4. Die Transistoren 3, 4 liegen in Reihe zu einem n-Kanal-MOS-Transistor 5, dessen Source mit Masse verbunden ist. Gates der MOS-Transistoren 3, 4 sind zusammengeschaltet und mit dem Ausgang des Inverters 2 verbunden. Außerdem ist der Eingang des Inverters 2 an den Knoten zwischen den Transistoren 3, 4 angeschlossen.

Ein Fuse-Initialisierungssignal FINIT mit dem in Fig. 2 gezeigten Verlauf ist einem Eingangsanschluss 6 zugeführt und liegt an Gate eines p-Kanal-MOS-Transistors 7 und an Gate des n-Kanal-MOS-Transistors 5. Außerdem ist ein Fuse-Setzsignal FSET einem Eingangsanschluss 8 zugeführt, der mit Gate eines n-Kanal-MOS-Transistors 9 verbunden ist. Die Transistoren 7 und 9 liegen in Reihe zu einer Fuse 10 und zu der Versorgungsspannung.
Beim Initialisieren der Fuselatch-Schaltung wird zunächst das Initialisierungssignal FINIT dem Eingangsanschluss 6 zugeführt, wodurch, sobald dieses Signal "hoch" (logisch "1") wird, der Transistor 5 öffnet, während der Transistor 7 schliesst. Zu dieser Zeit ist der Transistor 9 noch gesperrt. Nachdem das Fuse-Setzsignal FSET am Eingangsanschluss 8 hoch wird, öffnet der Transistor 9, so dass die Fuse-Information der Fuse 10 in das Latchglied 1 eingeschrieben werden kann. Nachdem das Fuse-Setzsignal FSET wieder abgefallen ist, sperrt der Transistor 9, so dass die Information im Latchglied 1 eingeschrieben bleibt.

Die bestehende Fuselatch-Schaltung von Fig. 2 erfordert zwingend zwei globale Steuersignale, nämlich die Signale FINIT und FSET, was einen erheblichen Aufwand an globaler Verdrahtung bedeutet und es außerdem schwierig macht, Laufzeitprobleme der beiden globalen Steuersignale zueinander bei der Verteilung über einen Chip zu verhindern.

Im einzelnen ist aus der US 5,566,107 eine Schaltungsanordnung bekannt, bei der eine Fuse zwischen den Source-Drain-Strecken eines ersten und eines zweiten MOS-Transistors des jeweils gleichen Leitungstyps gelegen ist, wobei Information aus der Fuse in ein Latchglied ausgelesen und dort abgespeichert wird. Der erste MOS-Transistor und ein weiterer MOS-Transistor sind durch Steuersignale angesteuert, die mittels eines Inverters zeitversetzt zueinander sind.

Es ist Aufgabe der vorliegenden Erfindung, eine Fuselatch-Schaltung anzugeben, die mit nur einem globalen Steuersignal auskommt, um so den Aufwand an globaler Verdrahtung zu verringern und das Auftreten von Laufzeitproblmene zwischen den globalen Steuersignalen zueinander auszuschliessen.

Diese Aufgabe wird bei einer Fuselatch-Schaltung der eingangs genannten Art erfindungsgemäß durch die im Patentanspruch 1 angegebenen Merkmale gelöst.

Bei der erfindungsgemäßen Fuselatch-Schaltung werden somit zusätzlich zu der bestehenden Schaltung zwei wesentliche weitere Maßnahmen angewandt:
(a) Eines der Steuersignale wird aus dem anderen globalen Steuersignal durch Zeitverzögerung gewonnen, wozu in vorteilhafter Weise Inverter eingesetzt werden können.
(b) Die Fuse wird erst nach der Initialisierung über einen Schalter, beispielsweise einen NMOS-Transistor, mit Masse verbunden, um einen Querstrom, der im Falle einer intakten Fuse vorhanden wäre, während der Initialisierung zu verhindern.

Nachfolgend wird die Erfindung anhand der Zeichnungen näher erläutert. Es zeigen:
- Fig. 1: ein Schaltbild zur Erläuterung der erfindungsgemäßen Fuselatch-Schaltung und
- Fig. 2: ein Schaltbild zur Erläuterung einer bestehenden Fuselatch-Schaltung.

Fig. 2 ist bereits eingangs beschrieben worden. In Fig. 1 werden für einander entsprechende Bauteile die gleichen Bezugszeichen wie in Fig. 2 verwendet.

Bei der erfindungsgemäßen Fuselatch-Schaltung wird zusätzlich zu der bestehenden Schaltung (vgl. insbesondere den links von Strichlinien 11 gelegenen Teil) ein Verzögerungsglied aus einem p-Kanal-MOS-Transistor 14, einem n-Kanal-MOS-Transistor 15 und einem n-Kanal-MOS-Transistor 17 vorgesehen, wobei diese Transistoren 14, 15 und 17 in Reihe zwischen Masse und einer Versorgungsspannung liegen. Einem Eingangsanschluß 16 wird wie einem Eingangsanschluß 6 das Fuse-Initialisierungssignal FINIT zugeführt, aus dem mit Hilfe des Verzögerungsgliedes aus den Transistoren 14, 15 und 17 ein Fuse-Setzsignal FSET gewonnen wird, das Gate des Transistors 9 (wie in Fig. 2) zugeführt wird. Der zusätzliche n-Kanal-MOS-Transistor 15 bewirkt dabei eine Zeitverzögerung τ zwischen den Signalen FINIT und FSET, d.h. einer Niedrig-Hoch-Flanke des Signales FINIT und einer Hoch-Niedrig-Flanke des Signales FSET.

Während der Initialisierungsphase wird das Signal FINIT auf logisch "0" ("niedrig") gesetzt, wodurch der Transistor 7 eingeschaltet wird und das Latchglied 1 mit logisch "1" ("hoch") vorinitialisiert ist. Das Signal FSET ist während der Initialisierung des Latchgliedes 1 auf logisch "1". Ein Querstrom durch eine intakte Fuse 10 wird durch den Transistor T5 verhindert.

Nach der Initialisierung wechselt das Signal FINIT von logisch "0" ("niedrig") auf logisch "1" ("hoch"). Aufgrund des Verzögerungsgliedes, bestehend aus den Transistoren T14, T15 und T17, bleibt das Signal FSET für eine Dauer τ auf logisch "1". Da nun der Transistor T5 eingeschaltet ist, wird die Fuseinformation wie folgt in das Latchglied 1 eingeschrieben:
(a) Ist die Fuse 10 intakt, wird der Eingang des Inverters 2 auf logisch "0" gezogen, wodurch das Latchglied 1 zurückgesetzt wird.
(b) Ist die Fuse 10 dagegen defekt (z.B. durch Laser beschossen, so wird eine logisch "1" ("hoch") im Latchglied 1 gespeichert.

Nach der Zeitdauer τ wechselt das Signal FSET auf niedrig, wodurch der Transistor 9 abgeschaltet und die Fuse von dem Latchglied 1 abgekoppelt wird.

Im Unterschied zu der bestehenden Fuselatch-Schaltung von Fig. 2 liegt bei der erfindungsgemäßen Fuselatch-Schaltung die Fuse 10 zwischen dem Transistor 9 und dem Knoten zwischen den Transistoren 4 und 5. Damit wird erreicht, daß beim Initialisieren der Schaltung im Falle intakter Fuses kein Querstrom fließt.

Gegebenenfalls können zur Verzögerung auch noch zwei Inverter 12, 13 zusätzlich vorgesehen werden, brauchen dies aber nicht zu sein, da die Verzögerung auch allein in die Transistoren 14, 15, 17 "eingebaut" werden kann.

Die Erfindung ermöglicht also die lokale Erzeugung der erforderlichen Steuersignale aus nur einem globalen Signal, so daß wesentliche Vorteile hinsichtlich der Einsparung für die globale Verdrahtung und das Verhindern von Laufzeitproblemen der globalen Steuersignale zueinander bei der Verteilung über einen Chip zu erzielen sind.

## Patentansprüche

1. Fuselatch-Schaltung, bei der mittels eines ersten und eines zweiten Steuersignales, die zeitversetzt zueinander sind, einem Zustand einer Fuse (10) entsprechende Information aus der Fuse (10) in ein Latchglied (1) auslesbar und in diesem speicherbar ist, wobei
- zusätzlich zu dem ersten Steuersignal (FINIT) auch das zweite Steuersignal (FSET) aus nur einem globalen Initialisierungssignal mittels eines Verzögerungsgliedes (14, 15, 17; 12, 13) gewonnen ist, und
- die Fuse (10) zwischen den Source-Drain-Strecken eines ersten und eines zweiten MOS-Transistors (9, 5) jeweils eines ersten gleichen Leitungstyps liegt,
**dadurch gekennzeichnet, dass**
- die Fuse (10) zwischen einerseits einer Reiheschaltung aus dem ersten MOS-Transistor (9) und einem dritten MOS-Transistor (7) eines zweiten, zum ersten Leitungstyp entgegengesetzten Leitungstyps und andererseits dem zweiten MOS-Transistor (5) liegt, wobei der dritte MOS-Transistor (7) und der erste MOS-Transistor (9) in Reihe zu der Fuse (10) und zu einer Versorgungsspannung sind, und wobei die Fuse (10) nach Initialisierung über den zweiten MOS-Transistor (5) mit Masse verbindbar ist, und
- das globale Initialisierungssignal dem Verzögerungsglied (14, 15, 17; 12, 13) und als erstes Steuersignal (FINIT) Gate des dritten MOS-Transistors (7) zugeführt ist und das Verzögerungsglied (14, 15, 17; 12, 13) mit Gate des ersten MOS-Transistors(9) verbunden ist, um diesem so das zweite Steuersignal (FSET) zuzuführen.

2. Fuselatch-Schaltung nach Anspruch 1,
**dadurch gekennzeichnet,**
**dass** das Verzögerungsglied aus Transistoren (14, 15, 17) besteht.

3. Fuselatch-Schaltung nach Anspruch 2,
**dadurch gekennzeichnet,**
**dass** das Verzögerungsglied außerdem Inverter (13, 13) aufweist.

## Claims

1. Fuse-latch circuit in which, by means of a first and a second control signal, which are staggered over time with respect to one another, information corresponding to a state of a fuse (10) can be read from the fuse (10) into a latch element (1) and can be stored in the latter,
wherein,
- in addition to the first control signal (FINIT), the second control signal (FSET) is also obtained from only one global initialization signal by means of a delay element (14, 15, 17; 12, 13), and
- the fuse (10) is connected between the source-drain paths of a first and a second MOS transistor (9, 5) in each case of a first same conduction type,
**characterized in that**
- the fuse (10) is connected between, on the one hand, a series circuit comprising the first MOS transistor (9) and a third MOS transistor (7) of a second conduction type, opposite to the first conduction type, and on the other hand the second MOS transistor (5), the third MOS transistor (7) and the first MOS transistor (9) being connected in series with the fuse (10) and with a supply voltage, and it being possible for the fuse (10) to be connected to earth after initialization via the second MOS transistor (5), and
- the global initialization signal being fed to the delay element (14, 15, 17; 12, 13) and as first control signal (FINIT) to the gate of the third MOS transistor (7), and the delay element (14, 15, 17; 12, 13) being connected to the gate of the first MOS transistor (9), in order in this way to feed the second control signal (FSET) thereto.

2. Fuse-latch circuit according to Claim 1,
**characterized**
**in that** the delay element comprises transistors (14, 15, 17).

3. Fuse-latch circuit according to Claim 2,
**characterized**
**in that** the delay element additionally has inverters (13, 13).

## Revendications

1. Circuit de verrouillage à fusible, dans lequel, au moyen d'un premier et d'un deuxième signal de commande qui sont décalés dans le temps l'un par rapport à l'autre, de l'information correspondant à un état d'un fusible (10) peut être lu à partir du fusible (10) dans un élément (1) de verrouillage et peut y être mémorisé, dans lequel
- en plus du premier signal (FINIT) de commande, le deuxième signal (FSET) de commande est obtenu aussi à partir de seulement un signal global d'initialisation au moyen d'un élément (14, 15, 17, 12, 13) à retard, et
- le fusible (10) se trouve entre la section de source-drain d'un premier et d'un deuxième transistor (9, 5) MOS respectivement d'un premier même type de conductivité,
**caractérisé en ce que**
- le fusible (10) se trouve entre d'une part un circuit série constitué du premier transistor MOS et d'un troisième transistor MOS, d'un deuxième type de conductivité opposé au premier type de conductivité, et d'autre part, le deuxième transistor (5) MOS, le troisième transistor (7) MOS et le premier transistor (9) MOS étant en série avec le fusible (10) et avec une tension d'alimentation et le fusible (10) pouvant être après initialisation relié à la masse par le deuxième transistor (5) MOS, et
- le signal global d'initialisation est envoyé à l'élément (14, 15, 17, 12, 13) à retard et en tant que premier signal (FINIT) de commande à la grille du troisième transistor (7) MOS et l'élément (14, 15, 17, 12, 13) à retard est relié à la grille du premier transistor (9) MOS pour envoyer ainsi à celui-ci le deuxième signal (FSET) de commande.

2. Circuit de verrouillage à fusible, suivant la revendication 1,
**caractérisé**
**en ce que** l'élément à retard est constitué de transistors (14, 15, 17).

3. Circuit de verrouillage à fusible, suivant la revendication 2,
**caractérisé**
**en ce que** l'élément à retard a en outre un inverseur (13, 13).
